# DEMANDE DE BREVET EUROPEEN

(11) **EP 1 324 494 A1**
(43) Date de publication de la demande: **02.07.2003**
(21) Numéro de dépôt: 02080676.6
(22) Date de dépôt: 16.12.2002
(51) Int. Cl.: H03K 17/945

(54) **Détecteur comportant des moyens de dialogue déportés**

(30) Priorité: 26.12.2001 FR 0117105
(71) Demandeur: Schneider Electric Industries SAS, 92500 Rueil-Malmaison (FR)
(72) Inventeur: Pitault, Gérard, 16600 Ruelle (FR); Vedelago, Victorio, 16710 Saint Yrieix (FR)

(57) **Abrégé**

La présente invention concerne un détecteur de proximité comportant un boîtier (10) et délivrant un signal de sortie (15) dont l'état est fonction de la position d'une cible (5) ou de la fréquence de passage d'une cible (5), le détecteur étant susceptible d'être paramétré par un opérateur à l'aide de moyens de dialogue opérateur (35) communiquant avec le détecteur par des signaux de dialogue (14). Les moyens de dialogue (35) sont séparés du boîtier (10) du détecteur et peuvent être intégrés dans un bloc de raccordement (30) relié au boîtier (10) du détecteur par un cordon de connexion (20) qui transporte les signaux de dialogue (14) et le signal de sortie (15) du détecteur.

## Description

La présente invention se rapporte à un détecteur de proximité de type inductif, capacitif, magnétique ou photoélectrique, comportant des moyens de dialogue déportés pour permettre à un opérateur d'exécuter notamment une fonction d'apprentissage du détecteur.

Certains détecteurs de proximité possèdent un mode apprentissage pour effectuer l'auto-adaptation de la portée du détecteur par rapport à un environnement et/ou par rapport à une cible. En effet, la portée de détection propre à un tel appareil peut varier d'un détecteur à l'autre et, pour un même détecteur, varie selon les conditions de montage et d'environnement, en particulier pour un détecteur inductif noyé dans une masse métallique. De plus, certaines applications nécessitent d'être capable de changer la sensibilité du détecteur selon son utilisation. Il est donc utile de pouvoir faire l'apprentissage de la portée d'un détecteur de proximité sur son lieu d'utilisation. Un tel détecteur est notamment décrit dans le document EP1143620.

D'autres détecteurs de proximité sont utilisés pour effectuer du contrôle de rotation. Ils réunissent dans un même appareil des fonctions classiques de détection de présence d'une cible et des fonctions de comptage des informations reçues par le capteur pendant un temps donné pour comparaison avec par exemple une fréquence de déclenchement préréglée sur l'appareil, de façon à délivrer en sortie un signal résultat de cette comparaison. On obtient ainsi un appareil adapté pour traiter en particulier les problèmes de sous-vitesse ou de survitesse par rapport à une fréquence nominale.

Le document EP 1130403 décrit un détecteur à contrôle de rotation, devant lequel passe une cible dont on veut contrôler la fréquence de passage par rapport à une fréquence normale de passage. Ce détecteur comporte des moyens de dialogue opérateur constitués d'un bouton-poussoir et d'une diode électroluminescente LED de dialogue sur le détecteur. Le bouton-poussoir sert à positionner le détecteur dans un mode travail ou dans un mode apprentissage. Le mode apprentissage permet au microcontrôleur du détecteur d'étalonner la fréquence normale de passage et permet de sélectionner une marge de fonctionnement du détecteur autour de cette fréquence normale. En mode apprentissage, la LED de dialogue associée au bouton-poussoir sert par exemple à guider l'opérateur dans le réglage de la marge de fonctionnement souhaitée du détecteur.

Cependant, la taille d'un détecteur de proximité étant souvent très réduite, il est difficile d'intégrer directement sur le produit les moyens de dialogue opérateur nécessaires pour effectuer ces fonctions d'apprentissage. Par ailleurs, les détecteurs de proximité étant souvent placés dans un environnement hostile pour l'homme, notamment lorsqu'ils sont à proximité de pièces de machines en mouvement, toute manipulation par un opérateur d'un bouton-poussoir qui serait directement monté sur le détecteur serait alors potentiellement dangereuse.

La présente invention a pour but de remédier à ces inconvénients en proposant une solution permettant une implantation aisée des moyens de dialogue tout en garantissant une sécurité pour les opérateurs.

Pour cela, l'invention décrit un détecteur de proximité comportant un boîtier et délivrant un signal de sortie dont l'état est fonction de la position d'une cible devant ledit boîtier ou de la fréquence de passage d'une cible devant ledit boîtier, le détecteur comportant des moyens de dialogue opérateur communiquant avec le détecteur par des signaux de dialogue dans le but de permettre à un opérateur de paramétrer le détecteur. Selon l'invention, les moyens de dialogue sont séparés du boîtier du détecteur.

Selon une caractéristique, les moyens de dialogue sont intégrés dans un bloc de raccordement relié au boîtier du détecteur par un cordon de connexion qui transporte les signaux de dialogue et le signal de sortie du détecteur. Le bloc de raccordement comporte un connecteur de raccordement externe pour le signal de sortie du détecteur.

Selon une autre caractéristique les moyens de dialogue comprennent un bouton-poussoir et une LED de dialogue.

D'autres caractéristiques et avantages vont apparaître dans la description détaillée qui suit en se référant à un mode de réalisation donné à titre d'exemple et représenté par les dessins annexés sur lesquels :
- la figure 1 représente un schéma fonctionnel d'un détecteur de proximité selon l'invention,
- la figure 2 montre un mode de réalisation d'un détecteur muni d'un bloc de raccordement.

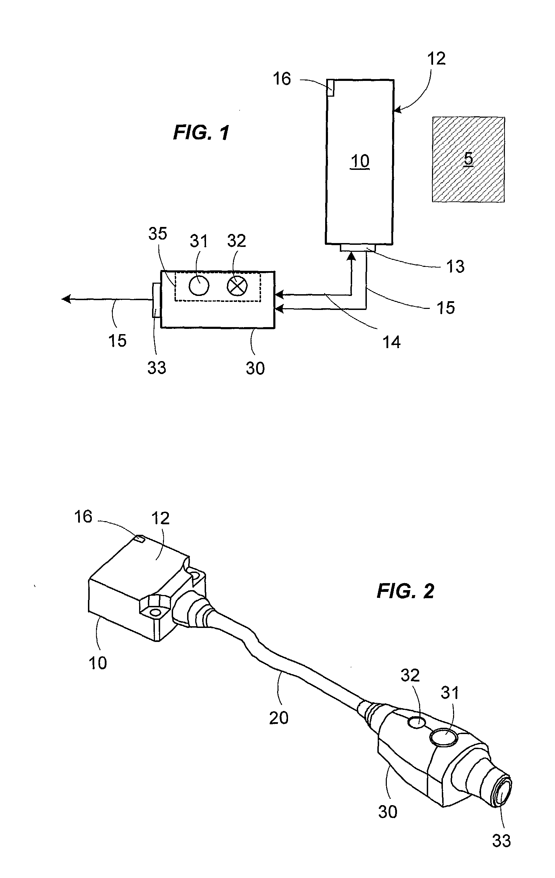

En référence à la figure 1, un appareil de détection comporte un boîtier 10, par exemple de forme parallélépipédique, muni d'une face de détection 12. Cet appareil de détection, appelé "détecteur" ou "détecteur de proximité" dans le présent document, est un détecteur de proximité inductif, capacitif, magnétique ou une cellule photoélectrique. Le détecteur est chargé de détecter la présence d'une ou plusieurs cibles 5 devant la face de détection 12 du boîtier 10, de façon à délivrer un signal de sortie 15, généralement binaire, qui est soit fonction directement de la position de la cible 5 devant la face de détection 12 pour une utilisation en simple détecteur de proximité, soit fonction de la fréquence de passage de la cible 5 devant la face de détection 12 pour une utilisation en contrôleur de rotation. Sur le boîtier 10, il est fréquent également de disposer d'une LED de signalisation 16 qui est traditionnellement l'image de la sortie 15.

Comme indiqué précédemment, un tel détecteur comporte souvent un mode apprentissage afin de permettre à un opérateur de régler un certain nombre de paramètres, comme par exemple la fréquence nominale de passage de la cible, la marge de fonctionnement ou la sensibilité du détecteur, le choix du mode de fonctionnement, etc... Ces paramètres sont déterminés par l'opérateur qui utilise pour cela des moyens de dialogue 35 simples du détecteur. Les moyens de dialogue permettent à l'opérateur de lire certaines informations venant du capteur mais aussi d'envoyer des informations vers le capteur. Les opérations de réglage peuvent être exécutées indifféremment lors de la fabrication du détecteur, lors de son montage initial sur site, lors de la mise en place d'une cible 20, mais aussi notamment lors d'opérations périodiques de maintenance.

Dans un mode de réalisation préféré, les moyens de dialogue 35 du détecteur sont constitués d'un organe d'entrée pour l'envoi d'informations, tel qu'un bouton-poussoir 31, et d'un organe de sortie pour la lecture d'informations, tel qu'une LED (diode électroluminescente ou DEL) 32 de dialogue, qui communiquent avec le détecteur par des signaux de dialogue 14. Grâce à de tels moyens de dialogue, on peut ainsi à moindre coût instituer des procédures simples de réglage permettant à un opérateur de paramétrer facilement le détecteur. On pourrait aussi envisager de remplacer le bouton-poussoir 31 par un commutateur par exemple.

Habituellement, ces moyens de dialogue 35 sont directement disposés sur le boîtier 10 du détecteur. Cependant, cette solution simple présente parfois des inconvénients en particulier lorsque la taille du boîtier 10 ne permet pas d'implanter facilement les moyens de dialogue 35 (détecteur de trop petite taille) ou lorsque le boîtier 10 est installé dans un emplacement non approprié pour l'intervention d'un opérateur (environnement machine dangereux).

C'est pourquoi, selon l'invention, les moyens de dialogue opérateur 35 du détecteur sont déportés par rapport au boîtier 10 du détecteur, de façon à se trouver dans une zone ne présentant pas de danger pour un opérateur.

Avantageusement, les moyens de dialogue 35 sont alors intégrés dans un bloc de raccordement 30 qui est relié au boîtier 10 par un cordon de connexion 20. L'alimentation électrique des moyens de dialogue 35 provient uniquement du détecteur. Il s'agit donc bien d'un déport des moyens de dialogue du détecteur et non de l'utilisation de moyens de dialogue extérieurs. Une première extrémité de ce cordon de connexion 20 est fixée au bloc de raccordement 30, par exemple par surmoulage. Selon un mode de réalisation préféré, le cordon de connexion 20 comporte au total cinq conducteurs ou fils pour transporter d'une part les signaux de dialogue 14 qui sont nécessaires à la communication entre les moyens de dialogue 35 et le boîtier 10 et d'autre part le signal de sortie 15 du détecteur.

Le signal de sortie 15 d'un détecteur est véhiculé généralement sur deux ou trois fils suivant la technologie utilisée pour la connexion (par exemple, connexion de type AC/DC en technologie deux fils : "signal" et "-", ou connexion de type DC en technologie trois fils : "+", "-" et "signal"). Pour des moyens de dialogue constitués d'un bouton-poussoir 31 et d'une LED de dialogue 32, les signaux de dialogue 14 sont alors véhiculés soit sur les trois fils restants dans une connexion de type AC/DC, soit sur les deux fils restants dans une connexion de type DC. Dans ce dernier cas, ces deux fils sont utilisés respectivement pour le signal du bouton-poussoir et de la LED, le commun étant raccordé sur le fil "-" du signal de sortie 15.

Le bloc de raccordement 30 comprend également un connecteur de raccordement externe 33 permettant de rendre disponible le signal de sortie 15 du détecteur sur un câble extérieur. Ce connecteur externe 33 est par exemple de type M12, de type K ou autres. Indifféremment, le connecteur externe 33 pourrait aussi ne comporter que des bornes sur lesquelles on viendrait brancher un câble extérieur pour récupérer le signal de sortie 15 du détecteur.

La longueur du cordon de connexion 20 est suffisante pour que le bloc de raccordement 30 ne soit plus situé dans la zone dangereuse du boîtier 10 et pour néanmoins conserver une proximité réelle entre le bloc de raccordement 30 et le boîtier 10 du détecteur. Typiquement cette longueur est de l'ordre de cinq à cinquante centimètres et préférentiellement de dix à vingt centimètres.

Dans une première variante, la seconde extrémité du cordon de connexion 20 est directement fixée sur le boîtier 10 du détecteur. Cette fixation est avantageusement réalisée par surmoulage du cordon de connexion 20 sur le boîtier 10. Ainsi, comme représenté en figure 2, chaque détecteur comporte systématiquement un bloc de raccordement 30 qui est muni de moyens de dialogue 35 pour le paramétrage du détecteur et d'un connecteur externe 33 pour délivrer le signal de sortie 15 du détecteur.

Dans une seconde variante, le boîtier 10 du détecteur comprend un connecteur de raccordement interne 13. Ce connecteur interne 13 permet de venir raccorder de manière amovible la seconde extrémité d'un cordon de connexion 20 muni d'un connecteur complémentaire au connecteur interne 13. De façon avantageuse, le connecteur interne 13 et le connecteur externe 33 sont du même type de sorte qu'un câble de raccordement extérieur connecté à l'un des connecteurs 13,33 peut également se connecter à l'autre connecteur. Ainsi, il devient facile de venir insérer un bloc de raccordement 30 dans une installation existante pour bénéficier temporairement des moyens de dialogue 35. En effet, dans une installation où le connecteur interne 13 du boîtier 10 d'un détecteur est initialement connecté directement à un câble extérieur, l'opération consiste à déconnecter le câble extérieur du connecteur interne 13, puis à brancher un bloc de raccordement 30 sur le connecteur interne 13, et enfin à rebrancher le câble extérieur sur le connecteur externe 33 du bloc de raccordement 30. Comme le cordon de liaison 20 et le connecteur externe 33 du bloc de raccordement 30 véhiculent le signal de sortie 15, le fonctionnement du détecteur peut alors continuer normalement. Cette opération a simplement comme effet d'insérer les moyens de dialogue 35 d'un bloc de raccordement 30 entre le détecteur et le câble extérieur, de manière à effectuer temporairement des fonctions de paramétrage sur le détecteur. En effectuant l'opération inverse, on peut aisément revenir au raccordement initial, le bloc de raccordement 30 amovible redevenant alors disponible, par exemple pour paramétrer d'autres détecteurs. Cette variante permet alors d'économiser le nombre de blocs de raccordement utilisés. Elle permet également de s'assurer qu'aucune modification du paramétrage n'est effectuée de façon intempestive sur un détecteur.

Ainsi, dans le cas où il existe un connecteur interne 13 sur le boîtier 10, ce connecteur interne 13 est adapté pour pouvoir se raccorder soit avec un câble extérieur de façon à délivrer le signal de sortie 15, soit avec un cordon de liaison 20 de façon à délivrer le signal de sortie 15 et les signaux de dialogue 14. Avantageusement, un connecteur de type M12 permet de rendre disponible l'ensemble de ces signaux sur un même connecteur, l'utilisation de tel ou tel signal étant alors uniquement fonction des connexions présentes sur le connecteur complémentaire, présent sur le câble extérieur et le cordon de liaison 20, que l'on vient brancher au connecteur interne 13.

Il est bien entendu que l'on peut, sans sortir du cadre de l'invention, imaginer d'autres variantes et perfectionnements de détail et de même envisager l'emploi de moyens équivalents.

## Revendications

1. Détecteur de proximité comportant un boîtier (10) et délivrant un signal de sortie (15) dont l'état est fonction de la position d'une cible (5) devant ledit boîtier (10) ou de la fréquence de passage d'une cible (5) devant ledit boîtier (10), le détecteur comportant des moyens de dialogue (35) communiquant avec le détecteur par des signaux de dialogue (14) dans le but de permettre à un opérateur de paramétrer le détecteur, **caractérisé par le fait que** les moyens de dialogue (35) sont séparés du boîtier (10) du détecteur.

2. Détecteur de proximité selon la revendication 1, **caractérisé par le fait que** les moyens de dialogue (35) sont intégrés dans un bloc de raccordement (30) relié au boîtier (10) du détecteur par un cordon de connexion (20) qui transporte les signaux de dialogue (14) et le signal de sortie (15) du détecteur.

3. Détecteur de proximité selon la revendication 2, **caractérisé par le fait que** le bloc de raccordement (30) comporte un connecteur de raccordement externe (33) pour le signal de sortie (15) du détecteur.

4. Détecteur de proximité selon la revendication 3, **caractérisé par le fait que** le cordon de connexion (20) est surmoulé sur le boîtier (10) du détecteur.

5. Détecteur de proximité selon la revendication 3, **caractérisé par le fait que** le boîtier (10) du détecteur comporte un connecteur de raccordement interne (13) pour se raccorder de manière amovible au cordon de connexion (20).

6. Détecteur de proximité selon la revendication 5, **caractérisé par le fait que** le connecteur de raccordement externe (33) et le connecteur de raccordement interne (13) sont de même type.

7. Détecteur de proximité selon l'une des revendications précédentes, **caractérisé par le fait que** les moyens de dialogue (35) comprennent un bouton-poussoir (31) et une LED de dialogue (32).
